# NEUE EUROPÄISCHE PATENTSCHRIFT

(11) **EP 0 160 290 B2**
(45) Veröffentlichungstag und Bekanntmachung des Hinweises auf die Entscheidung über den Einspruch: **10.06.1998**
(45) Hinweis auf die Patenterteilung: 02.09.1992
(21) Anmeldenummer: 85105184.7
(22) Anmeldetag: 27.04.1985
(51) Int. Cl.: H01H 11/04, C23C 26/00

(54) **Kontaktwerkstoff**
contact material
matériau de contact

(30) Priorität: 30.04.1984 DE 3416122
(43) Veröffentlichungstag der Anmeldung: 06.11.1985
(73) Patentinhaber: INOVAN GmbH & Co. KG Metalle und Bauelemente, D-75217 Birkenfeld (DE)
(72) Erfinder: Weik, Günter, Dipl.-Ing. (FH), D-7534 Birkenfeld (DE)
(74) Vertreter: Trappenberg, Hans

(56) Entgegenhaltungen:
- EP-A- 87 132
- EP-A- 0 092 754
- DE-A- 2 540 944
- DE-A- 2 540 999
- DE-A- 3 143 549
- DE-C- 1 270 692
- DE-C- 2 350 394
- FR-A- 890 260
- FR-A- 1 558 380
- FR-A- 2 208 993
- FR-A- 2 340 605
- US-A- 3 671 702
- IBM TECHNICAL DISCLOSURE BULLETIN, Band 19, Nr. 7, Dezember 1976, Seite 2495, New York, US; W.M. ALBRECHT et al.: "Palladium-gold plating for high-temperature application"
- Sonderndruck aus Heft 1, 41. Jahrgang 1987, S. 42, Metall-Verlag GmbH, 1000 Berlin 33
- Robert J. Russel: "Diffused Gold: An Alternative to Plated Gold for High Reliability", Z. Electronic Packaging and Production, Materials, Jan. 1983, S. 238-240

## Beschreibung

Die Erfindung betrifft einen Kontaktwerkstoff, bestehend aus einem Basismetall (oder einer Basis-Metallegierung), auf das eine Kontaktschicht aus Silber oder einer Silberlegierung oder aus Palladium oder einer Palladium legierung aufgebracht ist, deren Kontaktfläche, um die Bildung resistenter, den Kontakt-Übergangswiderstand unzulässig erhöhender Korrosionsschichten zu verhindern, durch eine 0,1 µm bis 1 µm dicke Goldschicht korrosionsgeschützt ist, wobei die Schichten einer thermischen Diffusionsbehandlung ausgesetzt wurden.

Kontaktwerkstoffe mit einer Kontaktschicht aus Silber oder Palladium beziehungsweise aus einer Silber- oder Palladiumlegierung sind mit dem Nacnteii behaftet, daß sich aui ihrer Oberfläche scnon nach kurzer Zeit eine dünne, jedoch äußerst resistente Korrosionsschicht bildet, die zu einem unzulässig hohen Kontakt-Übergangswiderstand führt. Trotz der sonstigen guten Eigenschaften derartiger Kontaktwerkstoffe werden daher immer noch Kontaktwerkstoffe verwendet, die zumindest an der Kontaktstelle stark vergoldet sind.

Aus dem Artikel von Robert J. Russell "Diffused Gold: An Alternative to Plated Gold for High Reliability "Elelectronic packging and production, January 1983, Seiten 238 bis 240, ist ein Kontaktwerkstoff bekannt, bei dem auf eine Konaktschicht aus einer Palladium-Silber-Legierung eine Goldschicht mit einer Dicke von 0,127 µm bis 0,762 µm aufgebracht ist. Die Goldschicht wird in die darunterliegende Palladium-Silber-Legierungsschicht eindiffundiert, wobei Zeit- und Temperaturbedingungen nicht angegeben sind. Der Auftrag der Goldschicht erfolgt dabei durch Walzplattlerung. Zwar wird auch eine elektrochemische Aufbringung offenbart, die jedoch wegen eines hohen Goldverbrauchs als negativ beschrieben ist. Bei dem bekannten Kontaktwerkstoff ist die Goldkonzentration über die Schichtdicke ausgehend von der Oberfläche nicht konstant.

Aufgabe der Erfindung ist daher, Kontaktwerkstoffe zur Verfügung zu stellen, die gegenüber den von Russell beschriebenen Produkten im Hinblick auf die Vermeidung der Erhöhung des Kontakt-Übergangswiderstandes durch Korrosionsschichten verbessert sind.

Bekannt - nach der DE-OS 25 40 999 - ist es, derartige Kontaktschichten mit einer Hauchvergoldung von etwa 0.5 µm bis 1.0 µm zu versehen. Tatsächlich kann durch eine solche Hauchvergoldung zumindest die Bildung störender Korrosionsschichten hinausgezögert werden. Allerdings biiden sich dann, relativ zu den unbehandelten Kontakten, Korrosionsschichten, die deutlich resistenter sind.

Möglich ist selbstverständlich auch eine Starkvergoldung, die jedoch, durch den hohen Goldanteil, recht unwirtschaftlich ist. Hinsichtlich der Wirtschaftlichkeit zwischen der Hauchvergoldung und einer solchen Starkvergoldung liegend ist es auch nach der FR-A-23 40 605 bereits bekannt, derartige Kontakte mit einer 5,0 µm bis 20 µm dicken Gold/Silber-Legierung abzudecken. Derartige Abdeckungen haben sich als recht brauchbar erwiesen, da sie die Bildung der beschriebenen Korrosionsschichten weitgehend verhindern und auch noch wirtschaftlich einigermaßen tragbar sind.

Bei reinen Palladiumkontakten, bei denen dieses Problem, wenn auch in abgeschwächter Form, ebenfalls auftritt, wird auch bereits (nach der DE-OS 31 43 549) so vorgegangen, daß eine dicke Goldschicht mechanisch aufplattiert wird, in mehreren Arbeitsstufen auf Endmaß gewalzt wird, hierbei mehrere Zwischenglühungen bei 510 °C durchgeführt werden und der Kontakt dann kurzzeitig einer Temperatur von etwa 760 °C ausgesetzt wird. Durch diese Temperaturbehandlung diffundiert das Gold in das darunter befindliche Palladium ein mit dem Erfolg, daß sich eine korrosionsschützende Miscnmetallschicht bildet, mit einem, von der Oberfläche her gesehen, stetig sinkenden Goldanteil.

Ganz allgemein ist es bekannt, auf aus Silber, einer Silberlegierung bestehenden, oder auf versilberte Gegenstände eine metallische Schicht niederzuschlagen oder diese Gegenstände mit Metallen zu plattieren, die von Silber verschieden sind (FR-A-22 08 993). Diese allgemeine Anweisung - sie nennt beispielsweise praktisch sämtliche Metalle einschließlich der Edelmetalle, die für diesen Zweck verwendet werden könnten - läßt jedoch ohne erfinderisches Zutun nicht die Lösung er gestellten Aufgabe zu. Weiter dem Stande der Technik zuzuzählen ist auch noch eine FR-A-23 40 605, die allerdings wiederum von einer Starkvergoldung im Bereich zwischen 5 µm und 20 µm ausgeht. Schließlich ist auch noch zu erwähnen die DE-A-25 40 999, die allerdings lediglich eine Änderung der Legierungszusammensetzung an der Oberfläche eines elektrischen Sleckkontaktes zum Inhalt hat, derart, daß wenigstens im Bereich der kontaktgebenden Oberfläche die Palladium-Konzentration größer ist als in der sich anschließenden Zone Selbstverständlich bilden sich auch auf einem derart hergestellten Palladiumkontakt wieder die oben schon erwähnten, äußerst resistenten Korrosionsschichten, die nach dieser Literaturstelle dadurch vermieden werden sollen, daß die Kontakte in einem letzten Verfahrensschritt mit einer Goldschicht in einer Dicke von 0.05 µm bis 0,8 µm bedeckt werden Diese dünne Goldauflage ist jedoch. wie dem Fachmann bekannt, porös, mit dem Erfolg, daß doch wieder resistente, den Kontakt-Übergangswiderstand stark beeinflussende Korrosionsschichten entstehen.

Nach der Erfindung wird die oben angeführte Aufgabe gelöst und ein Kontaktwerkstoff mit einer Kontaktschicht aus Silber oder einer Silberlegierung, oder aus Palladium oder einer Palladiumlegierung angegeben, die wiederum mit einer Korrosionsschutz-Goldschicht versehen ist, die erhalten wird durch Vergoldung auf galvanischem Weg oder durch chemische Dampfplattierung oder durch Kathodenzerstäubung Sputtern) in einer Dikke von 0,1 µm bis 1 µm und anschließender Temperaturbehandlung bei 350 °C bis 650 °C, während 10 sec. bis 1000 sec.

Tatsächlich hat sich gezeigt, daß diese so erhaltene Korrosionsschutz-Goldschicht hinsichtlich der Vermeidung von störenden Korrosionsschichten gleichzustellen ist einer Starkvergoldungsschicht mit einer Schichtdicke, die über 5 µm liegt. Es ergibt sich, wie ermittelt werden konnte, eine Mischmetallschicht, wobei das aufgebrachte Gold in das Grundmetall - Silber oder Palladium oder eine der Legierungen - eindiffundiert. Es kann angenommen werden, daß sich durch den Goldauftrag nach einem der beschriebenen Verfahren keine Fremdmoleküle mehr zwischen dieser Goldschicht und dem darunterliegenden Kontaktwerkstoff befinden. Durch das kurzzeitige Erhitzen kann die Diffusion des Goldes in den Kontaktwerkstoff stattfinden. Bemerkenswert ist, daß dies der letzte Arbeitsgang ist, daß also nur einmal, nach dem Goldauftrag, ein Glühvorgang stattfinden muß, die Diffusion des Goldes also exakter definiert werden kann.

Festzuhalten ist, daß derart hergestellte Kontaktwerkstoffe nach durchgeführtem Korrosionstest und nach Auslagerung in feuchter Wärme Kontaktwiderstandswerte ergaben, die gleich oder nur geringfügig schlechter waren als diejenigen mit der deutlich unwirtschaftlicheren, verhältnismäßig dikken Gold/Silber-Abdeckschicht.

Selbstverständlich ist der Kontaktwerkstoff nicht nur bei Einzelkontakten, sondern auch bei Kontaktprofilen mit großem Vorteil anzuwenden.

## Patentansprüche

1. Kontaktwerkstoff, welcher aus einem Basismetall oder einer Basis-Metallegierung besteht, auf welchem/welcher eine Kontaktschicht aus Silber oder einer Silberlegierung, oder aus Palladium oder einer Palladiumlegierung aufgebracht ist, deren Kontaktfläche, um die Bildung resistenter, den Kontakt-Übergangswiderstand unzulässig erhöhender Korrosionsschichten zu verhindern, durch eine 0,1 µm bis 1 µm dicke Goldschicht korrosionsgeschüzt ist, wobei die Schichten einer thermischen Diffusionsbehandlung ausgesetzt werden,
dadurch gekennzeichnet,
daß die Goldschicht auf galvanischem Weg oder durch chemische Dampfplattierung oder durch Kathodenzerstäubung aufgebracht ist sowie der Kontaktwerkstoff abschließend einmal für die Dauer von 10 sec. bis 1000 sec. bei 350°C bis 650°C geglüht ist.

## Claims

1. A contact material comprising a base metal or a base metal alloy to which is applied a contact layer of silver or a silver alloy or palladium or a palladium alloy, the contact surface of which is protected from corrosion by a layer of gold which is from 0.1 µm to 1 µm in thickness, to prevent formation of resistant layers of corrosion which unacceptably increase the contact transfer resistance, wherein the layers are subjected to a thermal diffusion treatment characterised in that said gold layer is applied to by goldplating galvanically or by chemical vapour plating or by cathode sputtering and said contact material is subsequently glued once for a period of 10 sec. to 1000 sec. at from 350°C to 650°C.

## Revendications

1. Matériau de contact, composé d'un métal de base ou d'un alliage métallique de base sur lequel est déposée une couche de contact en argent ou en un alliage d'argent, ou en palladium ou en un alliage de palladium, dont la suface de contact, afin d'empêcher la formation de couches de corrosion plus résistantes augmentant de manière inacceptable la résistance de passage par le contact, est protégée contre la corrosion par une couche d'or de 0,1 µm à 1 µm d'épaisseur, les couches étant soumises à un traitement de diffusion thermique, caractérisé en ce que la couche d'or est déposée par voie électrolytique ou par placage chimique en phase vapeur ou par pulvérisation cathodique et le matériau de contact est finalement recuit une fois pendant une période de 10 sécondes à 1000 sécondes par 350°C à 650°C.
